# EUROPEAN PATENT SPECIFICATION

(11) **EP 2 279 530 B1**
(45) Date of publication and mention of the grant of the patent: **26.06.2013**
(21) Application number: 09731395.1
(22) Date of filing: 08.04.2009
(51) Int. Cl.: H01L 31/052, H01L 31/0224

(54) **METHOD FOR IMPROVING PV AESTHETICS AND EFFICIENCY**
VERFAHREN ZUM VERBESSERN DER PV-ÄSTHETIK UND EFFIZIENZ
PROCÉDÉ D'AMÉLIORATION DE L'ESTHÉTIQUE ET DE L'EFFICACITÉ D'UN DISPOSITIF PHOTOVOLTAÏQUE (PV)

(30) Priority: 11.04.2008 US 44443
(43) Date of publication of application: 02.02.2011
(73) Proprietor: QUALCOMM MEMS Technologies, Inc., San Diego, CA 92121 (US)
(72) Inventor: SAMPSELL, Jeffrey, B., Pueblo West CO 81007 (US); KOTHARI, Manish, Cupertino CA 95014 (US); GRUHLKE, Russell, W., Milpitas CA 95035 (US)
(74) Representative: Dunlop, Hugh Christopher
(86) International application number: PCT/US2009/039965
(87) International publication number: WO 2009/126745

(56) References cited:
- WO-A1-95/15582
- WO-A1-2007/073203
- US-A- 5 110 370
- US-A- 5 261 970
- US-A- 6 008 449
- US-A1- 2007 125 415
- US-B1- 6 323 415

## Description

### BACKGROUND

### Field

The field of the disclosure relates generally to PV devices, for example improving the efficiency of photovoltaic devices and solar cells by recovering light that would otherwise not generate photovoltaic power.

### Description of the Related Art

For over a century fossil fuel such as coal, oil, and natural gas has provided the main source of energy in the United States. The need for alternative sources of energy is increasing. Fossil fuels are a non-renewable source of energy that is depleting rapidly. The large scale industrialization of developing nations such as India and China has placed a considerable burden on the available fossil fuel. In addition, geopolitical issues can quickly affect the supply of such fuel. Global warming is also of concern in recent years. A number of factors are thought to contribute to global warming; however, widespread use of fossil fuels is presumed to be a main cause of global warming. Thus there is an urgent need to find a renewable and economically viable source of energy that is also environmentally safe. Solar energy is an environmentally safe renewable source of energy that can be converted into other forms of energy such as heat and electricity.

While photovoltaic devices have the potential to reduce reliance upon hydrocarbon fuels, the widespread use of photovoltaic devices has been hindered by inefficiency and aesthetic concerns. Accordingly, improvements in either of these aspects could increase usage of photovoltaic devices.

As explained in US2007/125415, crystalline silicon PV modules typically use tinned flat copper wire to increase the conductivity of a bus bar metallization and to interconnect to adjacent cells. Such a flat bus wire may be patterned with shallow v-shaped grooves using metal forming techniques, such as rolling, stamping and drawing. The grooves are designed so that incident light is reflected up toward the glass superstrate of the module at an internal interface angle that is large enough (greater than about 40°) so that the light undergoes total internal reflection at the glass-air interface and is reflected onto the solar cell. Grooves can be lengthwise along the conductor, or at an angle, or angles. Rather than grooves, inclined faces can form pyramids, or other shapes.

### SUMMARY

Various embodiments comprise a photovoltaic device or array having improved efficiency. The present invention relates to a photovoltaic device as set out in claim 1, a method of manufacturing a photovoltaic device as set out in claim 9, and a photovoltaic module as set out in claim 18.

### BRIEF DESCRIPTION OF THE FIGURES

FIGS. 1 and 2 are schematic plan and isometric sectional views depicting an example solar photovoltaic device with visible reflective electrodes on the front side.

FIG. 3 schematically depicts two photovoltaic cells connected by a tab or ribbon.

FIG. 4 is a schematic plan view of an array of photovoltaic cells.

FIG. 5 is a schematic plan view of a thin film photovoltaic module.

FIG. 6 is a schematic cross-sectional view of an embodiment of a photovoltaic device having a microstructure on a conductor that is configured to reflect light so that the light is predominantly totally internally reflected off a total-internal-reflection surface forward or in front of the photovoltaic active material.

FIG. 7 is a schematic cross-sectional view of an embodiment of a photovoltaic device having a surface forward of a conductor configured to redirect light rays so that the redirected light is predominantly incident on a photovoltaic material.

FIG. 8 is a schematic cross-sectional view of an embodiment of a photovoltaic device having a diffuser formed on or forward of a conductor in a photovoltaic cell within an array of photovoltaic cells in a module.

FIG. 9 is a schematic cross-sectional view of an embodiment of a photovoltaic device having a scatter surface or element forward of a microstructure and rearward of a total-internal-reflection surface such that some light reflected from the microstructure is then redirected toward a photovoltaic material.

FIG. 10 is a schematic cross-sectional view of an embodiment of a photovoltaic module having a diffuser formed forward of a gap between photovoltaic cells within an array of photovoltaic cells.

FIG. 11 depicts a process flow for manufacturing an improved efficiency photovoltaic module.

### DETAILED DESCRIPTION OF PREFERRED EMBODIMENTS

A typical photovoltaic device can convert light energy into electrical energy or current. A photovoltaic device is an example of a renewable source of energy that has a small carbon footprint and has low impact on the environment. Using photovoltaic devices can reduce the cost of energy generation and provide possible cost benefits. Photovoltaic devices can have many different sizes and shapes, e.g., from smaller than a postage stamp to several inches across. Several photovoltaic devices can often be connected together to form photovoltaic modules that may be up to several feet long and a few feet wide. Modules, in turn, can be combined and connected to form photovoltaic arrays of different sizes and power output.

The size of an array applied to a particular situation can be adjusted depending on several factors, such as the amount of sunlight available in a particular location and the needs of the consumer. The modules of the array can include electrical connections, mounting hardware, power-conditioning equipment, and batteries that store solar energy for use when the sun is not shining. A photovoltaic device can be a single cell with its attendant electrical connections and peripherals, or a photovoltaic module or a photovoltaic array. A photovoltaic device can also include functionally unrelated electrical components, e.g., components that are powered by the photovoltaic device(s).

Current solar cells based on crystalline silicon wafers (and to a lesser extent amorphous thin film solar cells) utilize a network of conductors that are physically placed on the front surface of the cells and electrically connected to the photocurrent-generating substrate material. The conductors may be electrodes formed over the photovoltaic material of a photovoltaic device (including thin film photovoltaic devices) or the conductors may be tabs (ribbons) connecting individual devices together in a module and/or array. Photons entering a photovoltaic active material generate carriers throughout the material (except in the shadowed areas under the overlying conductors). The negatively and positively charged carriers (electrons and holes respectively), once generated, can travel only a limited distance through the photovoltaic active material before the carriers are trapped by imperfections in the substrates or recombine and return to a non-charged neutral state. Consequently, if photo-generated current were collected only at the edge of the photovoltaic device, very little current would be collected. The network of overlying conductive carriers solves this problem by collecting current over substantially the entire surface of the photovoltaic device. Most carriers will be collected by relatively thin lines at relatively close spacing throughout the surface of the photovoltaic device and the combined current from these thin lines flow through a few sparsely spaced and wider width bus lines to the edge of the photovoltaic device.

Unfortunately, there is an inherent trade-off between the size of the conductive lines and the amount of photocurrent that can be generated. As the lines become smaller, ohmic losses increase and the photovoltaic device output voltage decreases. As the lines become bigger, more device surface area is covered, more incident light is reflected away from the photovoltaic device, the total number of generated carriers decreases, and current output drops. The final configuration may be determined through an optimization, wherein a resultant percentage of photocurrent is lost due to the overlying conductor array.

Although the relatively small percentage of surface loss due to the conductors might seem inconsequential, this loss becomes important in the solar cell context for at least two reasons. First, the solar cell business model relies on amortizing solar cell cost over a long period of time. A relatively small increase in cell efficiency can make a large impact on amortization time. Second, solar cell production lines are very costly, and large performance improvements call for very expensive upgrades. Small improvements (on the order of the losses associated with the conductive leads) that can be implemented in current factories are highly valued. Therefore, eliminating or reducing the reflection/absorption losses due to the conductors can be an important improvement to solar cell performance. Reduction of reflections may also improve the aesthetics of photovoltaic devices, cells, and modules.

One issue hindering widespread adoption of photovoltaic (PV) devices and the placement of those devices on architectural surfaces for conversion of light energy into electric energy is the undesirable aesthetic appearance of front conductors or electrodes on the photovoltaic devices. The high reflectivity of common front electrode materials contrasts with the darker appearance of the active photovoltaic material itself, and furthermore hinders the blending of photovoltaic devices with surrounding materials. Reflection from front electrodes or conductors also reduces the efficiency of photovoltaic devices, including solar cells, as up to 20% or more of a photovoltaic device may be covered by reflective electrodes. For example, conductors may make up anywhere between 10% to 20% of photovoltaic device surface area (on the front, light incident side) in some instances. Embodiments described herein employ optical elements, such as diffusers, holograms, and diffractive optical elements comprising microstructure formed on various surfaces or formed within volumes to redirect light in various ways, as disclosed herein. Such optical elements may improve the efficiency of photovoltaic devices by capturing light incident on the photovoltaic device that may otherwise have been reflected by specular conductors such as gridline or bus electrodes or tabs or ribbons used to connect several photovoltaic cells to form a module. The various described embodiments may increase capture of light by photovoltaic devices thereby increasing efficiency and aesthetics due to a reduction in light reflected from specular conductors.

Although certain preferred embodiments and examples are discussed herein, it is understood that the inventive subject matter extends beyond the specifically disclosed embodiments to other alternative embodiments and/or uses of the invention and obvious modifications and equivalents thereof. It is intended that the scope of the inventions disclosed herein should not be limited by the particular disclosed embodiments. Thus, for example, in any method or process disclosed herein, the acts or operations making up the method/process may be performed in any suitable sequence and are not necessarily limited to any particular disclosed sequence. Various aspects and advantages of the embodiments have been described where appropriate. It is to be understood that not necessarily all such aspects or advantages may be achieved in accordance with any particular embodiment. Thus, for example, it should be recognized that the various embodiments may be carried out in a manner that achieves or optimizes one advantage or group of advantages as taught herein without necessarily achieving other aspects or advantages as may be taught or suggested herein. The following detailed description is directed to certain specific embodiments of the invention. However, the invention can be embodied in a multitude of different ways. The embodiments described herein may be implemented in a wide range of devices that include photovoltaic devices for collection of light band photonic energy and its conversion to electricity.

In this description, reference is made to the drawings wherein like parts are designated with like numerals throughout. As will be apparent from the following description, the embodiments may be implemented in a variety of devices that comprise photovoltaic active material.

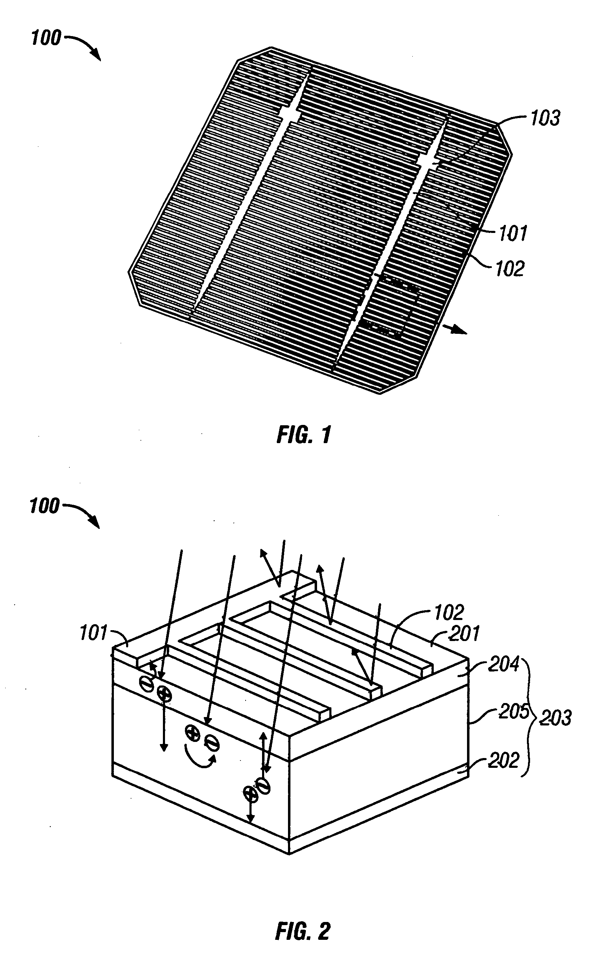

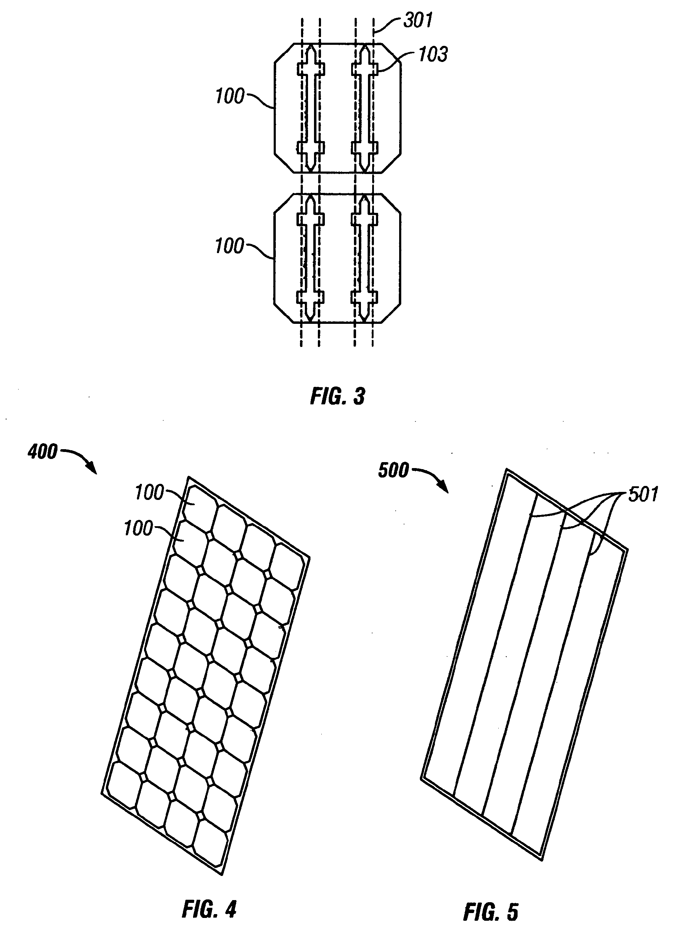

FIGS. 1 and 2 are schematic plan and isometric sectional views depicting an example photovoltaic device with visible reflective electrodes on the front side. As illustrated in FIGS.1 and 2, many photovoltaic devices 100 employ specularly reflective conductors 101, 102, 103 on a front side 201 (side on which light is incident) of the device as well as on a back side of the photovoltaic device. Conductors on the light-incident or front side 201 can comprise larger bus electrodes 101 and/or smaller gridline electrodes 102. The bus electrodes 101 may also comprise larger pads 103 for soldering or electrically connecting a ribbon 301 or tab. Ribbon 301 may be used to electrically connect multiple photovoltaic devices or cells together to form an array or module (as shown in FIGS. 3 and 4). When the front surface of the photovoltaic active material 203 is illuminated, photons transferenergy to electrons in the active region. If the energy transferred by the photons is greater than the band-gap of the semiconducting material, the electrons may have sufficient energy to enter the conduction band, resulting in an electron in the conduction band and a "hole" left in place of the electron. An internal electric field is created with the formation of the p-n junction. The internal electric field operates on the energized electrons (and holes) to cause these electrons (and holes) to move thereby producing a current flow in an external circuit. The resulting current flow can be used to power various electrical devices, or to generate electricity for distribution over a grid. These electrons and holes can generate current by moving to one or the other of the front electrodes (for example bus electrodes 101 or gridline electrodes 102) or back electrodes 202, as shown in FIG. 2. The electrodes 101, 102 are patterned to both reduce the distance an electron or hole travels to reach an electrode while also allowing enough light to pass through to the photovoltaic active layer(s). However, the front electrodes 101, 102 can reflect light which is therefore not used to generate a photocurrent or photovoltage, thereby reducing the efficiency of the photovoltaic device. Similarly, the front conductors may cause lines of bright reflections often considered to be unattractive, such that photovoltaic devices are often not employed in visible locations.

As illustrated in FIG. 2, a photovoltaic device may comprise a photovoltaic active region or photovoltaic active material 203 disposed between front electrodes 101, 102 and back electrodes 202. In some embodiments, the photovoltaic device 100 comprises a substrate on which a stack of layers is formed. The photovoltaic active material 203 of a photovoltaic device 100 may comprise a semiconductor material such as silicon. In some embodiments, the photovoltaic active material 203 may comprise a p-n junction formed by contacting an n-type semiconductor material 204 and a p-type semiconductor material 205 as shown in FIG. 2. Such a p-n junction may have diode-like properties and may therefore be referred to as a photodiode structure as well.

The photovoltaic active layer(s) (illustrated as comprising n-type semiconductor material 204 and a p-type semiconductor material 205) are sandwiched between front electrodes 101, 102 and back electrodes 202. It is understood that while FIG. 2 illustrates the flow of electrons to front electrodes 101, 102 and the flow of "holes" to the back electrodes 202, the p-n junction could be reversed so that the flow of electrons and holes is also reversed. It is also understood that whether a material is an n-type semiconductor or a p-type semiconductor depends upon the materials used and the properties of those materials. The front electrodes 101, 102 and back electrodes 202 can be formed of aluminum, silver, or molybdenum or some other conducting material. The front electrodes 101, 102 are designed to cover a significant portion of the front surface of the p-n junction so as to lower contract resistance and increase collection efficiency. In embodiments wherein the front electrodes 101, 102 are formed of an opaque material, the front electrodes 101, 102 are configured to leave openings over the front of the photovoltaic active material 203 to allow illumination to impinge on the photovoltaic active material 203. In some embodiments, the front electrodes 101, 102 can include a transparent conductor, for example, transparent conducting oxide (TCO) such as tin oxide (SnO₂) or indium tin oxide (ITO). The TCO can provide good electrical contact and conductivity and simultaneously be relatively transparent to the incoming light. It is understood that the TCO is never completely transparent, and a design optimization of conductivity versus transmissivity for the TCO must be carried out just as a tradeoff of conductivity versus area coverage would be executed in the case of reflective electrodes. In some embodiments, the photovoltaic device can also comprise a layer of anti-reflective (AR) coating disposed over the front electrodes 101, 102. The layer of AR coating can reduce the amount of light reflected from the front surface of the photovoltaic device.

In some embodiments, the p-n junction shown in FIG. 2 can be replaced by a p-i-n junction wherein an intrinsic or un-doped semiconducting layer is sandwiched between a p-type and an n-type semiconductor. A p-i-n junction may have higher efficiency than a p-n junction. In some other embodiments, the photovoltaic device can comprise multiple junctions.

The photovoltaic active layer(s) can be formed by any of a variety of light absorbing, photovoltaic active materials such as crystalline silicon (c-silicon), amorphous silicon (α-silicon), cadmium telluride (CdTe), copper indium diselenide (CIS), copper indium gallium diselenide (CIGS), light absorbing dyes and polymers, polymers dispersed with light absorbing nanoparticles, III-V semiconductors such as GaAs, etc. Other materials may also be used. The light absorbing material(s) where photons are absorbed and transfer energy to electrical carriers (holes and electrons) is referred to herein as the photovoltaic active material 203 of the photovoltaic device 100, and this term is meant to encompass multiple active sublayers. The material for the photovoltaic active layer(s) can be chosen depending on the desired performance and the application of the photovoltaic device 100.

In some embodiments, the photovoltaic device 100 can be formed by using thin film technology (not illustrated). For example, in one embodiment, where optical energy passes through a transparent substrate, the photovoltaic device 100 may be formed by depositing a first or front electrode layer (e.g., TCO) over the back surface of the transparent substrate. That is to say that the front electrode is formed behind the transparent substrate, i.e., on a surface of the transparent substrate that is opposite the light incident side. Photovoltaic active material 203 is then deposited over (behind) the first electrode layer. A second electrode layer can be deposited over (behind) the layer of photovoltaic active material. The layers may be deposited using deposition techniques such as physical vapor deposition techniques, chemical vapor deposition techniques, electro-chemical vapor deposition techniques, etc. Thin film photovoltaic devices may comprise amorphous or polycrystalline materials such as thin-film silicon, CIS, CdTe or CIGS. Other materials may be used. Some advantages of thin film photovoltaic devices are small device footprint and scalability of the manufacturing process among others.

FIG. 3 schematically depicts two photovoltaic devices 100 connected by a tab or ribbon 301. The ribbon 301 connects bus electrodes 101 or other electrodes across multiple photovoltaic devices 100, cells, dies, or wafers to form photovoltaic modules (as shown in FIG. 4), which can increase the output voltage by adding the voltage contributions of multiple photovoltaic devices 100 as may be desired according to the application. The ribbon 301 may be made of copper or other highly conductive material. This ribbon 301, like the bus 101 or gridline 102 electrodes, may reflect light, and may therefore also reduce the efficiency of the photovoltaic device 100. Therefore, the embodiments disclosed below may be applied to ribbon 301 or to any conductor on a front side 201 of a photovoltaic device 100 that prevents light from reaching the photovoltaic active material 203 thereby resulting in loss of energy.

FIG. 4 is a schematic plan view of multiple photovoltaic cells arranged to form a photovoltaic module 400. The photovoltaic cells comprising the module may include photovoltaic devices 100 similar to those depicted in FIGS. 1-3. As mentioned previously, the bus electrodes 101, gridline electrodes 102, pads 103, and the ribbons 301 may reflect light that is not then utilized for conversion into electricity. Hence, the overall performance of the photovoltaic module 400 may be reduced due to these reflections.

A photovoltaic module 400 may comprise multiple layers in the packaging of the multiple photovoltaic cells that are included in the module 100. These layers may include a cover glass in front of the photovoltaic devices 100. Behind the glass may be included ethylene vinyl acetate (also known as EVA or acetate) as an encapsulation material for the photovoltaic devices 100 or cells. Hence, the EVA, in some embodiments, may form a layer both in front of as well as behind the photovoltaic devices 100. A polyvinyl fluoride (Tedlar) backsheet may be formed behind EVA-encapsulated photovoltaic devices 100 to form the photovoltaic module 400. In some embodiments, the cover glass, EVA-encapsulated photovoltaic devices 100 (electrically connected together with ribbons), and the Tedlar backsheet may be framed on the edges by a metallic frame, such as an aluminum frame. Other methods of packaging a photovoltaic module 400 are also possible.

FIG. 5 is a schematic plan view of a thin film photovoltaic module 500. In some embodiments, thin film photovoltaic modules 500 may be monolithically integrated as a single module, and hence may not comprise an array of electrically connected photovoltaic cells 100 (as illustrated in FIG. 4). In such embodiments, thin film photovoltaic modules 500 may use fewer conductors on the surface than photovoltaic cells, and therefore less light may be lost due to reflection from the conductors. The film photovoltaic modules 500 may have relatively fewer reflecting conductors due to the use of a layer of a transparent conducting material, such as a transparent conducting oxide (TCO), formed over the thin film photovoltaic material comprising the thin film photovoltaic module 500. Common TCOs include indium tin oxide (ITO), and the layer of TCO may reduce the need for gridline electrodes 102 formed throughout the front of the thin film photovoltaic module 500. However, as shown in FIG. 5, even a thin film photovoltaic module 500 may comprise reflective bus conductor lines 501 which may reduce the efficiency and aesthetics of the thin film photovoltaic module 500. Indeed, due to the improvements in efficiency disclosed herein, the optimization of a thin film photovoltaic module 500 may now result in more conductors (e.g. bus electrodes) formed in front of thin film photovoltaic module 500 to reduce ohmic losses while losses due to reflection are also reduced..

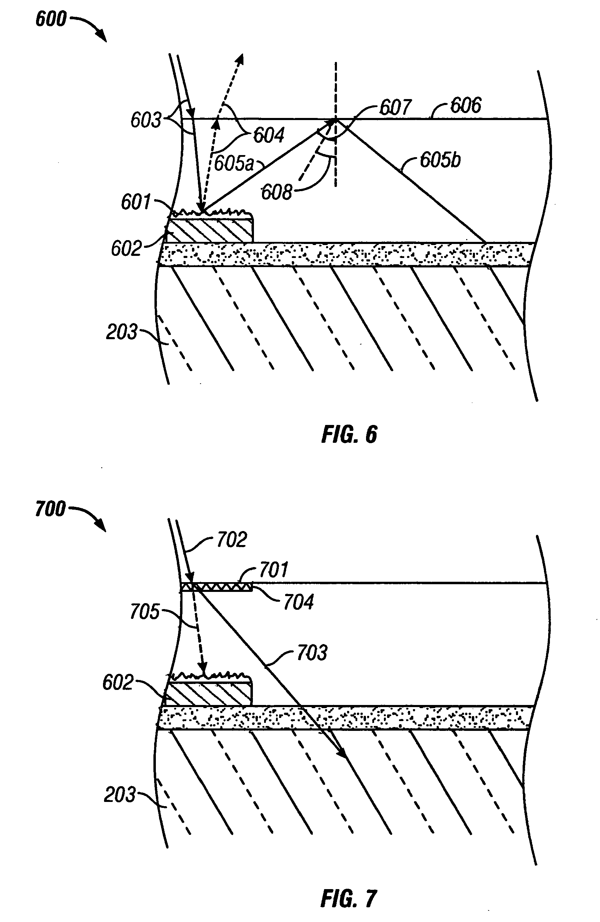

FIG. 6 is a schematic cross-sectional view of an embodiment of a photovoltaic device 600 having microstructure 601 configured to reflect light in such a way that a substantial portion of the light striking microstructure 601 is subsequently totally internally reflected. In various embodiments, microstructure 601 may comprise diffusing features of a diffuser, a light scatterer, or diffractive features of a diffractive optical element, such as a diffraction grating or hologram. Microstructure 601 may comprises, in some embodiments, a surface or volume hologram. In some embodiments, microstructure 601 comprises a blazed diffraction grating. Blazed gratings may be designed so that the first order diffraction is diffracted at an angle such that the first order is subsequently totally internally reflected. Blazed gratings may be formed by many closely spaced, periodic titled structures, such as many closely spaced rooftop-like structures, or a saw-tooth shaped grating. In some embodiments, the microstructure 601 may be formed on a conductor 602 or it may be formed on an optical layer that is formed over or in front of the conductor 602. The conductor 602 may be any conductor associated with a photovoltaic device 100 which reflects light that otherwise may have been absorbed by the photovoltaic active material 203 of the photovoltaic device 100. For example, conductor 602 may include bus electrodes 101, gridline electrodes 102, pads 103, ribbon 301, bus conductor lines 501, or a TCO electrode. TCO electrodes may be particularly useful in thin film applications, although they may also find use in other photovoltaic applications, particularly as the conductivity of TCO materials continues to improve. In an example embodiment, microstructure 601 may be formed holographically in an optical medium that is then applied to or formed onto the conductor 602. In other embodiments, the microstructure 601 may be formed using processes such as, for example, micro-embossing, micro-etching, and plasma etching of the reflective conductor. In an alternative embodiment, a photosensitive material may be formed over the conductor 602 and then holographically exposed to form microstructure 601 with the desired properties as discussed herein. In some embodiments, diffusive coatings may be grown anodically, or by PVD techniques to form non-planar, diffusive coatings. In some embodiments, a pressure sensitive adhesive could be formed into a scattering microstructure 601. In some embodiments, a viscous spin on glass material may be mixed with silica particles to form a diffusive microstructure 601. Other processes may be used.

As shown with the dotted arrow in FIG. 6, the conductor 602 (without the microstructure 601) may have reflected incoming light 603 out of the photovoltaic device 100, resulting in escaping light 604 which translates into light energy that is lost. However, in various embodiments, the microstructure 601 can scatter, diffuse, and/or reflect incoming light 603 such that light 605a may hit a total-internal-reflection surface 606 at an angle 607 larger than the critical angle 608. Hence light 605a is totally internally reflected back toward the photovoltaic active material 203 allowing the capture, and conversion to electricity, of the energy in light ray 605b.

In embodiments where the conductor 602 comprises a ribbon 301, the microstructure 601 may be formed on the ribbon 301 in ways similar to those discussed above. Additionally, the ribbon 301 may be formed by winding a sheet of conductor from roll to roll while performing such processes as micro-embossing, micro-etching, plasma etching the reflective conductor, or forming a photosensitive material onto the sheet (and subsequently forming a diffractive optical element, e.g., hologram in the photosensitive material). The sheet may then be cut to form ribbon 301 that is then used to electrically connect multiple photovoltaic cells together. The ribbon 301 may typically have thicknesses between 0.08 mm and 0.3 mm, and widths between 1.5 mm and 15 mm. The edges of the conductor layer may be angled or rounded. The length of ribbon 301 may be made as long as necessary to connect the desired number of photovoltaic devices 100.

The prefabricated ribbon 301 can then be interconnected with the conductors 101, 102, 103, 501 of multiple photovoltaic devices 100 to form a module or a solar panel or array. The skilled artisan will appreciate that microstructure 601 on ribbon 301 can also be obtained by soldering the ribbon 301 to electrically connect multiple photovoltaic devices 100 followed by, for example, plasma etching the ribbon 301. Alternatively, microstructure 601 may be formed on a tape substrate, or other layer (not shown), optionally with a release layer (not shown). The microstructure 601 may then be laminated onto the ribbon 301 using a pressure sensitive adhesive or other suitable means either before or after it is soldered or otherwise electrically connected to the photovoltaic devices 100.

Total-internal-reflection surface 606 may be formed at any interface between a high index of refraction material and a lower index of refraction material. For example, total-internal-reflection surface 606 may be formed at the interface between a cover glass of any photovoltaic device 100 or photovoltaic module (such as photovoltaic module 400 or thin film photovoltaic module 500) and ambient air (or other low index material). While FIG. 6 illustrates only one layer (e.g., a conformal coating such as EVA) over the conductor 602 and photovoltaic active layer 203, it is understood that many layers may be formed in front of the conductor 602 and photovoltaic active layer 203. For example, the conductor 602, microstructure 601, and photovoltaic active layer 203 may be encapsulated in a layer of EVA as an encapsulation material for the photovoltaic devices 100 or cells with a cover glass over the EVA. In this case surface 606 would likely be located at the outer surface of the cover glass, since the index of refraction of the EVA and the cover glass may be similar. Other encapsulation materials may be used. In cases where the encapsulation layer has a higher index of refraction than the index of refraction of the layer in front of it, total-internal-reflection surface 606 will be formed at the interface between the encapsulation layer and the layer in front of it. In cases where the encapsulation layer has a lower index of refraction than the index of refraction of the layer in front of it, total-internal-reflection surface 606 will be formed at the air interface of the layer in front of the encapsulation layer. The photovoltaic device 600 may also comprise other layers, e.g., a transparent conductive material layer 609 between photovoltaic active material 203 and conductor 602.

FIG. 7 is a schematic cross-sectional view of an embodiment of a photovoltaic device 700 having a surface 701 forward of a conductor 602, the surface 701 being configured to redirect incident light rays 702 so that some of the redirected light 703 is incident on a photovoltaic active material 203. In various embodiments, the surface 701 may comprise a diffuser or a hologram. While the term "surface" is used, it is understood that surface 701 may also comprise a volume, e.g., a volume hologram, or a layer of a given thickness. More generally, the surface 701 may comprise a surface or volume hologram, a diffractive optical element, diffractive features, a diffuser, diffusing features, or other optical element capable of redirecting and/or deflecting light as described herein. Surface 701 may be formed on a layer 704 that is placed or formed in front of the conductor 602. In some embodiments, the layer 704 may be patterned to substantially conform to and/or align with the pattern formed by conductor 602 over the surface of the photovoltaic device 100. In some embodiments, the surface 701 redirects and/or deflects light 705 that would have hit the conductor 602, redirecting it toward the photovoltaic active material 203 so that it may be absorbed by the photovoltaic active material 203. Surface 701 redirects light before it would have otherwise hit conductor 602, thereby reducing losses associated with conductor 602 (such as reflection). In some embodiments, conductor 602 may cause loss by means other than reflection, such as absorption. Hence conductor 602 may result in loss of light energy not only by reflection, but by absorption as well (as in a transparent or semi-transparent conductor in which some light energy may be lost by absorption).

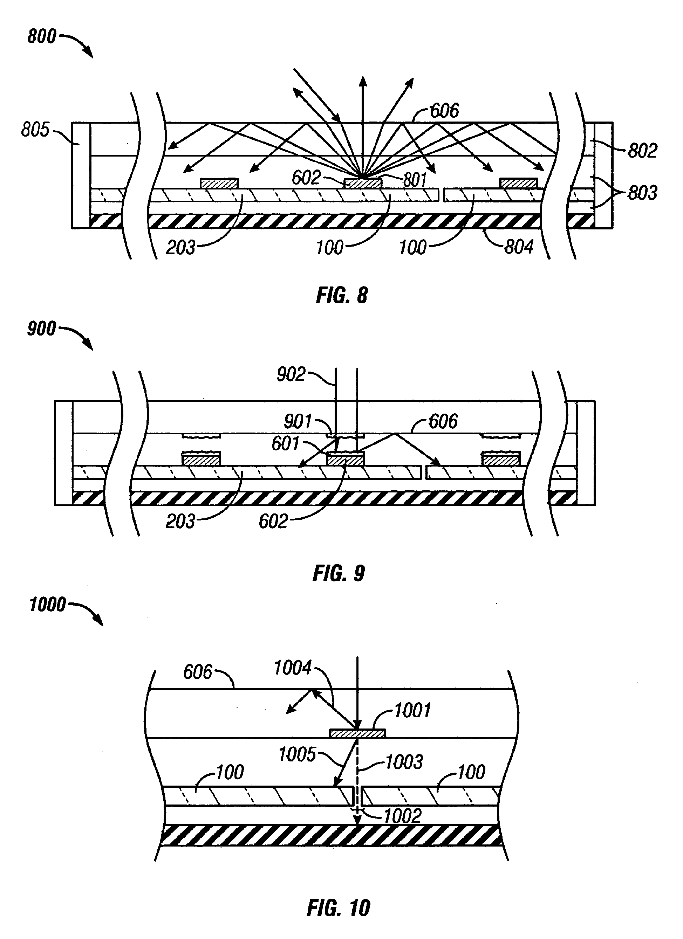

FIG. 8 is a schematic cross-sectional view of an embodiment of a photovoltaic module 800 having a diffuser 801 formed on or forward a conductor 101, 102, 103 of a photovoltaic device 100. As illustrated, the photovoltaic device 100 is in an array of photovoltaic devices 100 in a photovoltaic module 800 (like that of FIG. 4). However, diffuser 801 may be formed on the conductor 602 of any photovoltaic device 100 such as an individual photovoltaic cell, on cells in a photovoltaic module, or in a monolithically integrated module, such as a thin film photovoltaic module 500. The diffuser 801 may be formed from any structure with the desired optical function, such as, for example, a hologram (e.g., holographic diffuser), or by roughening the surface of the conductor 602. Alternatively, diffractive optical elements may be used such as diffraction gratings. The diffuser 801 may be a diffusing tape that can be adhered onto the conductors 602. Alternatively, the diffuser 801 may comprise a spray-on diffuser, such as white paint sprayed onto the conductors in addition to imparting a microstructure to the conductors. Other types of diffusers may be employed. The diffuser 801 may diffuse the light in many different directions. In some embodiments, the diffuser 801 may diffuse the light over 180° (i.e., ±90° from normal to the front surface of conductor 602). In some such embodiments, the diffuser 801 may be a Lambertian diffuser and diffuse the light evenly over the 180°. In such embodiments, some light diffused from the Lambertian diffuser will not be incident on a total-internal-reflection surface 606 at an angle greater than the total internal reflection angle and as such will not be redirected to the photovoltaic device. However, a Lambertian diffuser may diffuse enough light so as to be incident on a total-internal-reflection surface 606 at greater than the total internal reflection angle to appreciably improve the efficiency of a photovoltaic device. Since fabricating a pure Lambertian surface may be difficult given current technology, in other embodiments, the diffuser 801 may diffuse the light over a range of angles between 0° and 90° or 90° and 180°. It is understood that many ranges are achievable, but that practical diffusers are not perfect. Therefore, a practical diffuser configured to diffuse incident light, for example, at greater than ±45° from normal, will not diffuse all light at these angles. It is understood that the various ranges referred to indicate that less than 50% peak transmission is diffused (reflected) at angles outside of the given range. In some embodiments, the diffuser 801 may diffuse appreciable light from 50° from normal to as high as 85° degrees from normal. In some embodiments, the intensity of light reflected from the diffuser 801 in some range of angles greater than the total internal reflection angle is greater than 70% of the light intensity reflected at the peak intensity angle (i.e., the angle with maximum reflected intensity). For example, the diffuser 801 may reflect greater than or equal to 70% of the light intensity reflected at the peak intensity angle in the range of 42° to 55° from normal (of the photovoltaic device surface). In some embodiments, the intensity of light reflected from the diffuser 801 in some range of angles greater than the total internal reflection angle is greater than 50% of the light intensity reflected at the peak intensity angle.

As illustrated in FIG. 8, the diffuser 801 may allow some of the light reflected from the conductor to be totally internally reflected off of a total-internal-reflection surface 606. As illustrated, the total-internal-reflection surface 606 is formed at the air-glass interface of a cover glass 802 (glass plate) or other high-index plate formed forward of the conductor 101, 102, 103. However, the device may be packaged in other ways. As illustrated, some portion of the light may be reflected normal or near normal to the total-internal-reflection surface 606 and escape. Preferably, the diffuser 801 diffuses a substantial amount of light such that the diffused light is then incident on a total-internal-reflection surface 606 at an angle greater than the critical angle. In any case, even pure Lambertian diffusion can result in a significant improvement in efficiency. Hence, in embodiments where the diffusion is non-Lambertian and the diffuser 801 may diffuse light such that a greater proportion of the light is then incident on a total-internal-reflection surface 606 at an angle greater than the critical angle, even greater improvements in efficiency are possible. For example, in some embodiments, less than 10% of the light is reflected within ± 10° of normal.

As illustrated, photovoltaic module 800 comprises photovoltaic devices 100 that are encapsulated in an encapsulation layer 803, often made of EVA. The photovoltaic module 800 also comprises a backsheet 804. Typically, the layers will be surrounded by a frame 805, often made of a metal, such as aluminum. However, in various other embodiments, more or fewer layers may be used, and other suitable materials may also substitute those mentioned above.

FIG. 9 is a schematic cross-sectional view of an embodiment of a photovoltaic device 100 having a scatterer 901 forward of microstructure 601 and rearward of a total-internal-reflection surface 606 such that light that may not totally internally reflect, such as light ray 902, is then redirected toward photovoltaic active material 203. As illustrated, the photovoltaic device 100 is in an array of photovoltaic devices 100 in a photovoltaic module 900 (like that of FIG. 4). However, scatterer 901 may be formed forward any photovoltaic device 100 such as an individual photovoltaic cell, on cells in a photovoltaic module, or in a monolithically integrated module, such as a thin film photovoltaic module 500. As mentioned above regarding FIG. 8, some light may reflect from the microstructure 601 at normal or near normal to the total-internal-reflection surface and escape. In some embodiments, the scatterer 901 comprises a hologram, diffraction grating, or diffuser that is placed forward of the microstructure 601 so as to scatter or redirect light reflected from the microstructure 601 at near normal angles back toward the photovoltaic active material 203. In other embodiments, conductor 602 may not comprise microstructure 601, and may reflect light as a specular conductor. In such embodiments, scatterer 901 may be configured to reflect light back at angles such that light reflected by scatterer 901 is subsequently absorbed by photovoltaic active material 203 for conversion to electricity. Scatterer 901 may also operate to refract, scatter, and/or diffract light incident on the device toward the photovoltaic active material 203. Accordingly, scatterer 901 may comprise transparent material and may comprise variations in index of refraction or a surface having a variegated topography.

FIG. 10 is a schematic cross-sectional view of an embodiment of a photovoltaic module 1000 having a diffuser 1001 formed forward of a gap 1002 between photovoltaic devices 100 within an array of photovoltaic cells. As illustrated with (dashed) light ray 1003, light may be lost in the gaps between photovoltaic devices 100 when the gaps are between adjacent cells in an array. Diffuser 1001 may help to recapture some of this otherwise lost light energy by reflecting the light such that light ray 1004 is incident upon a total-internal-reflection surface 606 at an angle greater than the critical angle and may hence be totally-internally reflected back toward a photovoltaic device 100 within the module 1000. Diffuser 1001 may have substantially the same properties as diffuser 801 discussed with respect to FIG. 8. The diffuser 1001 may be formed from any structure with the desired optical function, such as, for example, a hologram (e.g., holographic diffuser). Alternatively, diffractive optical elements may be used such as diffraction gratings. In other embodiments, the diffuser 1001 may help to recapture some of the otherwise lost light energy by deflecting (e.g., refracting) transmitted light, such as light ray 1005, toward a photovoltaic device 100 without total internal reflection.

In the various embodiments disclosed herein, the efficiency of a photovoltaic device may be improved. For example, between 30% to 65% of the conductor aperture is recovered (e.g., in a photovoltaic device with 10% to 20% conductor aperture). As used herein, the conductor aperture is the surface area covered by the conductor. Conductor aperture recovery corresponds to the amount of active area of the solar cell effectively recovered because light that would otherwise be blocked by the conductor reaches the active area as a result of deflection from the diffuser and redirection back onto exposed active area. Hence, 20% conductor aperture refers to a photovoltaic device with 20% of the surface area otherwise exposed to light that is instead covered by conductors. Conductor aperture recoveries in these ranges (e.g., 6 to 12%) can lead to an improvement in photovoltaic device efficiency of about 6% to 12% over devices with no aperture recovery. In some embodiments, from 30 to 65% conductor aperture recovery may be achieved.

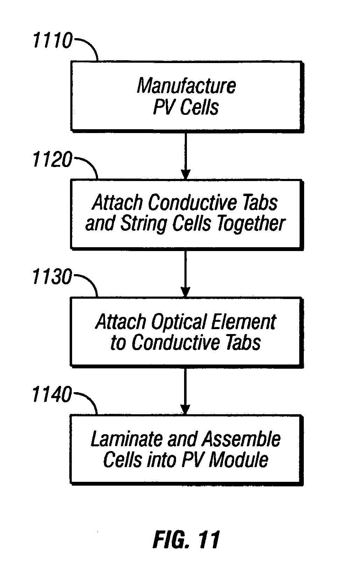

FIG. 11 depicts a process flow for manufacturing an improved efficiency photovoltaic module. As shown in FIG. 11, step 1110 comprises manufacturing photovoltaic cells. This may include steps such as appropriately doping various regions of a semiconductor wafer, applying conductors and electrodes to front and back surfaces of the wafer, forming microstructure onto conductors and electrodes as disclosed elsewhere herein, and other processes known in the art. In step 1120, conductive tabs are attached (see FIG. 3) to the photovoltaic cells. In step 1130 (optional), an optical element is attached or applied to the conductive tabs. The optical element may include any of the elements disclosed herein, such as a microstructure and/or diffuser (including a spray-on diffuser, such as white diffusive paint). In step 1140, the cells are then laminated and assembled into a photovoltaic module. Step 1130 may be done, as illustrated, after the attaching the conductive tabs to the cells. Alternatively, the conductive tabs may have optical elements pre-applied or the tabs may be pre-processed. For example, the conductive tabs may have a diffusive tape pre-attached onto the light incident side of the conductive tabs. Alternatively, the conductive tabs may be pre-processed with microstructure. Hence, in embodiments where the tabs come with pre-attached optical elements or are otherwise pre-processed, step 1120 may be followed by step 1140 without the intervening step 1130. In other embodiments, a surface is disposed forward the conductor, wherein the surface is configured to redirect incident light rays directed toward the conductor such that redirected light is instead incident on the photovoltaic material. The surface forward of a conductor is configured to redirect incident light rays so that some of the redirected light is incident on a photovoltaic active material, for example, in a photovoltaic cell, instead of the conductor. The "surface" may include a surface or volume hologram, or other optical element capable of redirecting and/or deflecting light as described with reference to FIG. 7 above. The surface may be formed on a layer that is placed or formed in front of the conductor, for example the surface may be formed on or be a part of glass and/or other material used to laminate the cells into the photovoltaic module in step 1140. Some embodiments may include patterning the surface to substantially conform to, align with, and/or correspond with the pattern of conductors in the photovoltaic cell or module. The surface may comprise a tape or laminate comprising a hologram or other optical element as discussed above. The tape or layer may be applied or laminated in the pattern, as discussed above, over the glass and/or other material placed forward of (light-incident side) the conductors. Other embodiments may include forming the surface directly on the glass and/or other material placed forward of the conductors by mechanical or chemical means. In various embodiments, the surface, whether a tape, laminate, or formed directly on the glass and/or other material placed forward of the conductors, redirects and/or deflects light that would have hit the conductor, redirecting it toward the photovoltaic active material so that it may be absorbed by the photovoltaic active material. In this way, the surface reduces losses associated with the conductor.

Although certain preferred embodiments and examples are discussed herein, it is understood that the inventive subject matter extends beyond the specifically disclosed embodiments to other alternative embodiments and/or uses of the invention and obvious modifications and equivalents thereof. It is intended that the scope of the inventions disclosed herein should not be limited by the particular disclosed embodiments. Thus, for example, in any method or process disclosed herein, the acts or operations making up the method/process may be performed in any suitable sequence and are not necessarily limited to any particular disclosed sequence. Various aspects and advantages of the embodiments have been described where appropriate. It is to be understood that not necessarily all such aspects or advantages may be achieved in accordance with any particular embodiment. Thus, for example, it should be recognized that the various embodiments may be carried out in a manner that achieves or optimizes one advantage or group of advantages as taught herein without necessarily achieving other aspects or advantages as may be taught or suggested herein.

## Claims

1. A photovoltaic device (100, 600, 700, 900) having a forward side (201) on which light is incident and a rearward side opposite the forward side, the photovoltaic device comprising:
means for generating electricity (203) from incident light;
means for conducting electricity (602) disposed forward of and in electrical contact with the electricity generating means (203), wherein the conducting means (602) reflects incident light;
a total internal reflection surface (606) disposed forward of the conducting and the electricity generating means (203, 602); and
a microstructure (601) rearward the total internal reflection surface (606), the microstructure (601) configured to reflect light so that at least some reflected light is incident upon the total internal relection surface (606) at an angle greater than a critical angle of the total internal reflection surface (606); **characterised in that** the photovoltaic device (100, 600, 700, 900) further comprises:
a light scattering means (701, 901) forward of the microstructure (601), the light scattering means configured to redirect reflected light from the microstructure (601) rearwards towards the means for generating electricity, wherein the redirected reflected light comprises light rays which would not be totally internally reflected by the total internal reflection surface (606).

2. The photovoltaic device (100, 600, 700, 900) of Claim 1, wherein:
the electricity generating means (203) comprises a photovoltaic material;
the conducting means (203, 602) comprises a conductor; and
the light scattering means (701, 901) comprises a hologram, diffraction grating, or light diffusing structure.

3. The photovoltaic device (100, 600, 700, 900) of Claim 1, wherein the microstructure (601) comprises diffusing features of one or more diffusers.

4. The photovoltaic device (100, 600, 700, 900) of Claim 1, wherein the microstructure (601) comprises diffracting features of one or more holograms.

5. The photovoltaic device (100, 600, 700, 900) of Claim 1, wherein microstructure (601) comprises one or more diffractive features of a diffractive optical element.

6. The photovoltaic device (100, 600, 700, 900) of Claim 1, wherein the microstructure (601) comprises a surface of the conductor.

7. The photovoltaic device (100, 600, 700, 900) of Claim 1, wherein a conductor aperture recovery is between about 30% to 65%.

8. The photovoltaic device (100, 600, 700, 900) of Claim 1, wherein an efficiency of the photovoltaic device is 6% or more greater than the efficiency of the photovoltaic device without the microstructure.

9. A method of manufacturing a photovoltaic device (100, 600, 700, 900) comprising:
providing a conductor (602) disposed with respect to a photovoltaic material (203) so as to be in electrical contact with the photovoltaic material (203), wherein the conductor (602) reflects incident light;
disposing a total internal reflection surface (606) forward of the conductor (602) and the photovoltaic material (203);
disposing a microstructure (601) rearward the total internal reflection surface (606), wherein the microstructure (601) is configured to reflect light so that at least some reflected light is incident upon the total internal reflection surface (606) at an angle greater than a critical angle of the total internal reflection surface (606); and
disposing a light scattering structure (701, 901) forward of the microstructure (601), the light scattering structure (701, 901) configured to redirect reflected light from the microstructure (601) rearwards towards the photovoltaic material (203), wherein the redirected reflected light comprises light rays which would not be totally internally reflected by the total internal reflection surface (606).

10. The method of Claim 9, wherein the conductor (602) comprises an electrode on a photovoltaic cell.

11. The method of Claim 9, wherein the conductor (602) comprises a tab connecting a plurality ofphotovoltaic cells in an array.

12. The method of Claim 9, wherein disposing the microstructure (601) comprises forming the microstructure (601) on a surface of the conductor (602).

13. The method of Claim 12, wherein forming the microstructure (601) on the surface of the conductor (602) comprises a process selected from the group consisting of micro-embossing, micro-etching, plasma etching the reflective conductor, and holography.

14. The method of Claim 9, wherein disposing the microstructure (601) comprises embedding particles on the forward side of the conductor (602).

15. The method of Claim 9, wherein disposing the microstructure (601) comprises forming a diffuser film on the forward side of the conductor (602).

16. The method of Claim 9, further comprising disposing a layer between the conductor (602) and the microstructure (601).

17. The method of Claim 16, wherein disposing the microstructure (601) comprises disposing a scattering film over the layer and aligning the scattering film over the conductor (602).

18. A photovoltaic module (400, 500, 800, 1000) comprising multiple photovoltaic devices of any of claims 1-8.

## Patentansprüche

1. Photovoltaik-Vorrichtung (100, 600, 700, 900) mit einer Vorderseite (201), auf die Licht fällt, und einer Rückseite, die der Vorderseite gegenüberliegt, wobei die Photovaltaik-Vorrichtung Folgendes umfasst:
ein Mittel zum Erzeugen von Elektrizität (203) aus einfallendem Licht;
ein Mittel zum Leiten von Elektrizität (602), das vor, und in elektrischem kontakt mit, dem Elektrizitätserzeugungsmittel (203) angeordnet ist, wobei das Leitungsmittel (602) einfallendes Licht reflektiert;
eine Totalreflexionsfläche (606), die vor dem Leitungs- und dem Elektrizitätserzeugungsmittel (203, 602) angeordnet ist; und
eine Mikrostruktur (601) hinter der Totalreflexionsfläche (606), wobei die Mikrostruktur (601) dafür konfiguriert ist, Licht so zu reflektieren, dass mindestens ein Teil des reflektierten Lichts auf die Totalreflexionsfläche (606) in einem winkel fällt, der größer als ein kritischer Winkel der Totalreflexionsfläche (606) ist; **dadurch gekennzeichnet, dass** die Photovoltaik-Vorrichtung (100, 600, 700, 900) des Weiteren Folgendes umfasst:
ein Lichtstreuungsmittel (701, 901) vor der Mikrostruktur (601), wobei das Lichtstreuungsmittel dafür konfiguriert ist, reflektiertes Licht von der Mikrostruktur (601) nach hinten zu dem Mittel zum Erzeugen von Elektrizität umzulenken, wobei das umgelenkte reflektierte Licht Lichtstrahlen umfasst, die nicht durch die Totalreflexionsfläahe (606) totalreflektiert werden würden.

2. Photovoltaik-Vorrichtung (100, 600, 700, 900) nach Anspruch 1, wobei:
das Elektrizitätserzaugungsmittel (203) ein Photovoltaikmaterial umfasst;
das Leitungsmittel (203, 602) einen Leiter umfasst, und
das Lichtstreuungsmittel (701, 901) ein Hologramm, ein Beugungsgitter oder eine Lichtdiffusionsstruktur umfasst.

3. Photovoltaik-Vorrichtung (100, 600, 700, 900) nach Anspruch 1, wobei die Mikrostruktur (601) Diffusionsmerkmale von einem oder mehreren Diffusoren umfasst.

4. Photovoltaik-Vorrichtung (100, 600, 700, 900) nach Anspruch 1, wobei die Mikrostruktur (601) Beugungsmerkmale von einem oder mehreren Hologrammen umfasst.

5. Photovoltaik-Vorrichtung (100, 600, 700, 900) nach Anspruch 1, wobei die Mikrostruktur (601) ein oder mehrere Beugungsmerkmale eines optischen Beugungselements umfasst.

6. Photovoltaik-Vorrichtung (100, 600, 700, 900) nach Anspruch 1, wobei die Mikrostruktur (601) eine Oberfläche des Leiters umfasst.

7. Photovoltaik-Vorrichtung (100, 600, 700, 900) nach Anspruch 1, wobei eine Leiteroffnungswiederherstellung zwischen etwa 30 % und 65 % beträgt.

8. Photovoltaik-Vorrichtung (100, 600, 700, 900) nach Anspruch 1, wobei ein Wirkungsgrad der Photovoltaik-Vorrichtung mindestens 6 % größer ist als der Wirkungsgrad der Photovoltaik-Vorrichtung ohne die Mikrostruktur.

9. Verfahren zur Herstellung einer Phatovoltaik-vorrichtung (100, 600, 700, 900), das Folgendes umfasst:
Bereitstellen eines Leiters (602), der mit Bezug auf ein Photovoltaikmaterial (203) so angeordnet ist, dass er in elektrischem Kontakt mit dem Photovoltaikmaterial (203) steht, wobei der Leiter (602) einfallendes Licht reflektiert;
Anordnen einer Totalreflexionsfläche (606) vor dem Leiter (602) und dem Photovoltaikmaterial (203);
Anordnen einer Mikrostruktur (601) hinter der Totalreflexionsfläche (606), wobei die Mikrostruktur (601) dafür konfiguriert ist, Licht so zu reflektieren, dass mindestens ein Teil des reflektierten Lichts auf die Totalreflexionsfläche (606) in einem Winkel fällt, der größer als ein kritischer Winkel der Totalreflexionsfläche (606) ist; und
Anordnen einer Lichtstreuungsstruktur (701, 901) vor der Mikrostruktur (601), wobei die Lichtstreuungsstruktur (701, 901) dafür konfiguriert ist, reflektiertes Licht von der Mikrostruktur (601) nach hinten in Richtung des Photovoltaikmaterials (203) umzulenken, wobei das umgelenkte reflektierte Licht Lichtstrahlen umfasst, die nicht durch die Totalreflexionsfläche (606) totalreflektiert werden würden.

10. Verfahren nach Anspruch 9, wobei der Leiter (602) eine Elektrode an einer Photovoltaikzelle umfasst.

11. Verfahren nach Anspruch 9, wobei der Leiter (602) eine Nase umfasst, die mehrere Photovoltaikzellen in einer Gruppierung verbindet.

12. Verfahren nach Anspruch 9, wobei das Anordnen der Mikrostruktur (601) das Ausbilden der Mikrostruktur (601) an einer Oberfläche des Leiters (602) umfasst.

13. Verfahren nach Anspruch 12, wobei das Ausbilden der Mikrostruktur (601) an der Oberfläche des Leiters (602) einen Prozess umfasst, der aus folgender Gruppe ausgewählt ist: Mikroprägen, Mikroätzen, Plasmaätzen des reflektierenden Leiters, und Holografie.

14. Verfahren nach Anspruch 9, wobei das Anordnen der Mikrostruktur (601) das Einbetten von Partikeln auf der Vorderseite des Leiters (602) umfasst.

15. Verfahren nach Anspruch 9, wobei das Anordnen der Mikrostruktur (601) das Ausbilden eines Diffusorfilms auf der Vorderseite des Leiters (602) umfasst.

16. Verfahren nach Anspruch 9, das des Weiteren das Anordnen einer Schicht zwischen dem Leiter (602) und der Mikrostruktur (601) umfasst.

17. Verfahren nach Anspruch 16, wobei das Anordnen der Mikrostruktur (601) das Anordnen eines Streuungsfilms über der Schicht und das Ausrichten des Streuungsfilms über dem Leiter (602) umfasst.

18. Photovoltaikmodul (400, 500, 800, 1000), das mehrere Photovoltaik-Vorrichtung nach einem der Ansprüche 1-8 umfasst.

## Revendications

1. Dispositif photovoltaïque (100, 600, 700, 900) ayant un côté avant (201) sur lequel de la lumière est incidente et un côté arrière opposé au côté avant, le dispositif photovoltaïque comprenant :
un moyen de production d'électricité (203) à partir de la lumière incidente ;
un moyen de conduction d'électricité (602) disposé devant et en contact électrique avec le moyen de production d'électricité (203), le moyen de conduction (602) réfléchissant la lumière incidente ;
une surface de réflexion interne totale (606) disposée devant les moyens de conduction et de production d'électricité (203, 602) ; et
une microstructure (601) derrière la surface de réflexion interne totale (606), la microstructure (601) étant configurée pour réfléchir la lumière de matière à ce qu'au moins une partie de la lumière réfléchie soit incidente sur la surface de réflexion interne totale (606) à un angle supérieur à un angle critique de la surface de réflexion interne totale (606) ; **caractérisé en ce que** le dispositif photovoltaïque (100, 600, 700, 900) comprend en outre :
un moyen de diffusion de la lumière (701, 901) devant la microstructure (601), le moyen de diffusion de la lumière étant configuré pour rediriger de la lumière réfléchie provenant de la microstructure (601) vers l'arrière en dircction du moyen de production d'électricité, la lumière réfléchie redirigée comprenant des rayons de lumière qui ne seraient pas totalement réfléchis d'une manière interne par la surface de réflexion interne totale (606).

2. Dispositifphotovoltaïque (100, 600, 700, 900) selon la revendication 1, dans lequel :
le moyen de production d'électricité (203) comprend un matériau photovoltaïque :
le moyen de conduction (203, 602) comprend un conducteur ; et
le moyen de diffusion de la lumière (701, 901) comprend un hologramme, un réseau de diffraction ou une structure diffusant la lumière.

3. Dispositif photovoltaïque (100, 600, 700, 900) selon la revendication 1, dans lequel la microstructure (601) comprend des éléments diffusants d'un ou plusieurs diffuseurs.

4. Dispositif photovoltaïque (100, 600, 700, 900) selon la revendication 1, dans lequel la microstructure (601) comprend des éléments diffractants d'un ou plusieurs hologrammes.

5. Dispositif photovoltaïque (100, 600, 700, 900) selon la revendication 1, dans lequel la microstructure (601) comprend un ou plusieurs éléments diffractants d'un élément optique diffractant.

6. Dispositif photovoltaïque (100, 600, 700, 900) selon la revendication 1, dans lequel la microstructure (601) comprend une surface du conducteur.

7. Dispositif photovoltaïque (100, 600, 700, 900) selon la revendication 1, dans lequel une récupération d'ouverture du conducteur est comprise entre environ 30% et 65%.

8. Dispositif photovoltaïque (100, 600, 700, 900) selon la revendication 1, dans lequel le rendement du dispositif photovoltaïque est supérieur de 6% ou plus au rendement du dispositif photovoltaïque sans la microstructure.

9. Procédé de fabrication d'un dispositif photovoltaïque (100, 600, 700, 900), comprenant :
la production d'un conducteur (602) disposé par rapport à un matériau photovoltaïque (203) de manière à être en contact électrique avec le matériau photovoltaïque (203), le conducteur (602) réfléchissant la lumière incidente ;
la disposition d'une surface de réflexion interne totale (606) devant le conducteur (602) et le matériau photovoltaïque (203) ;
la disposition d'une microstructure (601) derrière la surface de réflexion interne totale (606), la microstructure (601) étant configurée pour réfléchir la lumière de manière à ce qu'au moins une partie de la lumière réfléchie soit incidente sur la surface de réflexion interne totale (606) à un angle supérieur un angle critique de la surface de réflexion interne totale (606) ; et
la disposition d'une structure de diffusion de la lumière (701, 901) devant la microstructure (601), la structure de diffusion de la lumière (701, 901) étant configurée pour rediriger de la lumière réfléchie provenant de la microstructure (601) vers l'arrière en direction du matériau pltotovoltaïque (203), la lumière réfléchie redirigée comprenant des rayons de lumière qui ne seraient pas totalement réfléchis d'une manière interne par la surface de réflexion interne totale (606).

10. Procédé selon la revendication 9, dans lequel le conducteur (602) comprend une électrode sur une cellule photovoltaïque.

11. Procédé selon la revendication 9, dans lequel le conducteur (602) comprend une patte connectant une pluralité de cellules photovoltaïque dans un réseau.

12. Procédé selon la revendication 9, dans lequel la disposition de la microstructure (601) comprend la formation de la microstructure (601) sur une surface du conducteur (602).

13. Procédé selon la revendication 12, dans lequel la formation de la microstructure (601) sur la surface du conducteur (602) comprend un processus choisi dans le groupe comprenant le inicrogaufrage, la microgravure, la gravure par plasma du conducteur réfléchissant, et l'holographie.

14. Procédé selon la revendication 9, dans lequel la disposition de la microstructure (601) comprend l'incorporation de particules sur le côté avant du conducteur (602).

15. Procédé selon la revendication 9, dans lequel la disposition de la microstructure (601) comprend la formation d'un film diffusant sur le côté avant du conducteur (602).

16. Procédé selon la revendication 9, comprenant en outre la disposition d'une couche entre le conducteur (602) et la microstructure (601).

17. Procédé selon la revendication 16, dans lequel la disposition de la microstructure (601) comprend la disposition d'un film diffusant au-dessus de la couche et l'alignement du film diffusant au-dessus du conducteur (602).

18. Module photovoltaïque (400, 500, 800, 1000) comprenant de multiples dispositifs photovoltaïques selon l'une quelconque des revendications 1-8.
